# EUROPÄISCHE PATENTANMELDUNG

(11) **EP 1 061 648 A1**
(43) Veröffentlichungstag der Anmeldung: **20.12.2000**
(21) Anmeldenummer: 00111077.4
(22) Anmeldetag: 02.06.2000
(51) Int. Cl.: H03K 5/08

(54) **Verfahren zur drahtlosen elektromagnetischen Übertragung von Daten**

(30) Priorität: 15.06.1999 DE 19927320
(71) Anmelder: Mannesmann VDO Aktiengesellschaft, 60388 Frankfurt am Main (DE)
(72) Erfinder: Fleischhauer, Norbert, 65760 Eschborn (DE); Sievers, Christopher, 63450 Hanau (DE); Berberich, Reinhold, 60439 Frankfurt (DE)
(74) Vertreter: Rassler, Andrea, Dipl.-Phys.

(57) **Zusammenfassung**

Bei einem Verfahren zur drahtlosen elektromagnetischen Übertragung von Daten als binäre Signale, welche als amplitudenmoduliertes Signal von einer Sendeeinrichtung ausgesendet, von einer Empfangseinrichtung empfangen und über eine einstellbare Komparatorschwelle in ein Rechtecksignal umgesetzt werden, wird die Impulsbreite des demodulierten Signals durch Nachführen der Komparatorschwelle auf einem wenigstens abschnittsweise bestimmten Sollwert gehalten.

## Beschreibung

Die Erfindung betrifft ein Verfahren zur drahtlosen elektromagnetischen Übertragung von Daten als binäre Signale, welche als amplitudenmoduliertes Signal von einer Sendeeinrichtung ausgesendet, von einer Empfangseinrichtung empfangen und über eine einstellbare Komparatorschwelle in ein Rechtecksignal umgesetzt werden.

Zur Übertragung von Daten per Funk werden die Daten als binäre Signale häufig in amplitudenmodulierte Signale gewandelt, die durch Eigenschaften der Sendeeinrichtung mitunter eine beträchtliche Nachschwingdauer aufweisen, wodurch die ausgesendeten Signale verbreitert werden und es bei zu hoher Datenübertragungsrate zu Überschneidungen der Signale kommen kann. Dies ist insbesondere bei drahtlosen Identifikationseinrichtungen der Fall, deren Sender mit einem Antennenschwingkreis hoher Güte versehen ist.

Empfangene Signale werden über eine Eingangsschwelle bei der Demodulation in Rechtecksignale gewandelt. Dazu wird das empfangene Signal über einen Komparator mit einstellbarer Komparatorschwelle geführt. Die Komparatorschwelle wird bei gängigen Verfahren dem Gleichspannungsanteil der demodulierten Signale nachgeführt. Diese Art der Regelung der Komparatorschwelle eignet sich jedoch nur für gleichspannungsfreie Bitcodierverfahren.

Aufgabe der vorliegenden Erfindung ist es, ein Verfahren anzugeben, welches unabhängig von der Feldstärke der übertragenen Signale eine hohe Datenübertragungsrate ermöglicht. Das Verfahren soll auch für Signale mit vom Signalinhalt abhängigen Gleichspannungsanteil anwendbar sein.

Diese Aufgabe wird dadurch gelöst, daß die Impulsbreite des demodulierten Signals durch Nachführen der Komparatorschwelle auf einem wenigstens abschnittsweise bestimmten Sollwert gehalten wird. Die Komparatorschwelle kann mittels des erfindungsgemäßen Verfahrens auch bei gleichspannungsbehafteten Signalen nachgeführt werden. Durch die Nachführung der Komparatorschwelle kann die Datenübertragungsrate erhöht werden.

Eine erste Ausgestaltung der Erfindung sieht vor, daß der Sollwert der Impulsbreite des demodulierten Signals wenigstens abschnittsweise konstant vorgegeben ist. Dies ist bei derartigen Signalen vorteilhaft, bei denen der Abstand der Impulse zueinander mit der zu übermittelnden Information moduliert ist.

Es kann vorgesehen sein, daß die Impulsbreite des demodulierten Signals auf den Sollwert geregelt wird mit der Komparatorschwelle als Stellgröße. Eine Regelung ermöglicht die bestmögliche Flexibilität in der Anpassung der Komparatorschwelle.

Bei einer weiteren Ausgestaltung der Erfindung ist vorgesehen, daß das Signal einem Spitzenwertgleichrichter zugeführt wird und daß die Komparatorschwelle anteilig dem Spitzenwert nachgeführt wird. Die Zeitkonstante des Spitzenwertgleichrichters wird dazu vorteilhaft im Bereich des maximal zu erwartenden Impulsabstands des Signals gewählt. Eine zu geringe Zeitkonstante bewirkt eine zu starke Schwankung der Komparatorschwelle. Die Komparatorschwelle kann beispielsweise immer auf die Hälfte des von dem Gleichrichter erzeugten Spitzenwerts eingestellt werden.

Dabei kann vorgesehen sein, daß zur Demodulation die Hüllkurve des Signals gebildet wird. Dadurch läßt sich die Demodulation des Signals relativ einfach realisieren. Alternativ kann auch vorgesehen sein, daß die Schwingungen des Signals, welche die Komparatorschwelle überschreiten, gezählt werden und somit ein Maß für die Impulsbreite abgeleitet wird. Dies setzt allerdings voraus, daß der Mikro-Controller im Verhältnis zur Trägerfrequenz genügend schnell arbeitet.

Eine weitere Ausgestaltung des erfindungsgemäßen Verfahrens sieht vor, daß die Impulsbreite des demodulierten Signals bestimmt und mit dem Sollwert verglichen wird und daß in Abhängigkeit von dem Ergebnis des Vergleichs die Komparatorschwelle nachgeführt wird.

Dazu kann entweder vorgesehen sein, daß die Komparatorschwelle kontinuierlich nachgeführt wird oder daß zu Beginn einer Übertragung ein erster empfangener Impuls des Signals über eine von einem vorgegebenen untersten Wert stetig ansteigende Komparatorschwelle geführt wird und daß die Breite des daraus resultierenden Impulses bestimmt und daraus ein Wert für die Komparatorschwelle ermittelt wird, der beim nächsten empfangenen Impuls angewendet wird und weiter, daß vor jedem voraussichtlich zu empfangenden neuen Impuls des zu empfangenden Signals die Komparatorschwelle auf einen neuen Wert gesetzt wird, der anhand der Impulsbreite des vorherigen Impulses ermittelt wird, und daß der nächste empfangene Impuls des Signals zur Demodulation und Bestimmung der nächsten Impulsbreite über die neu gesetzte Komparatorschwelle geführt wird.

Diese stufenweise Nachführung der Komparatorschwelle läßt sich in einem Softwareprogramm leicht implementieren und funktioniert auch bei geringerer Rechenleistung eines ausführenden Mikro-Controllers, als dies für eine kontinuierliche Regelung notwendig ist. Die Ermittlung der als nächstes zu setzenden Komparatorschwelle kann anhand eines Kennlinienfeldes oder einer Reglerfunktion erfolgen, aus der die Impulsbreite in Abhängigkeit vom Signalpegel entnehmbar ist.

Zur Durchführung des erfindungsgemäßen Verfahrens ist bei einer nächsten Weiterbildung der Erfindung vorgesehen, daß das empfangene Signal parallel einem ersten Komparator und einer Vorrichtung zur Nachführung der Komparatorschwelle zugeführt wird und daß das Ausgangssignal des ersten Komparators über ein Hüllkurvenfilter und einen zweiten Komparator mit fester Schwelle geführt und in das Rechtecksignal gewandelt wird. Dadurch werden die Signalimpulse auch bei hohen Datenübertragungsraten noch klar voneinander getrennt und für einen Mikro-Controller erkennbar gemacht.

Ausführungsbeispiele der Erfindung sind in der Zeichnung anhand mehrerer Figuren dargestellt und in der nachfolgenden Beschreibung näher erläutert.

Es zeigt:
- Fig. 1: einen Signalimpuls eines mit dem erfindungsgemäßen Verfahren übertragbaren Signals,
- Fig. 2: schematisch die möglichen Auswirkungen eines wechselnden Signalpegels bei fester Komparatorschwelle,
- Fig. 3: ein Blockschaltbild der Signalbearbeitung bei der Durchführung eines erfindungsgemäßen Verfahrens mit kontinuierlich nachgeführter Komparatorschwelle,
- Fig. 4: ein schematisches Diagramm eines mittels einer kontinuierlich nachgeführten Komparatorschwelle demodulierten Signals,
- Fig. 5: ein Blockschaltbild der Signalverarbeitung mit stufenweise nachgeführter Komparatorschwelle und
- Fig. 6: ein schematisches Diagramm eines mittels einer stufenweise nachgeführten Komparatorschwelle demodulierten Signals.

Gleiche Teile sind in den Figuren mit gleichen Bezugszeichen versehen.

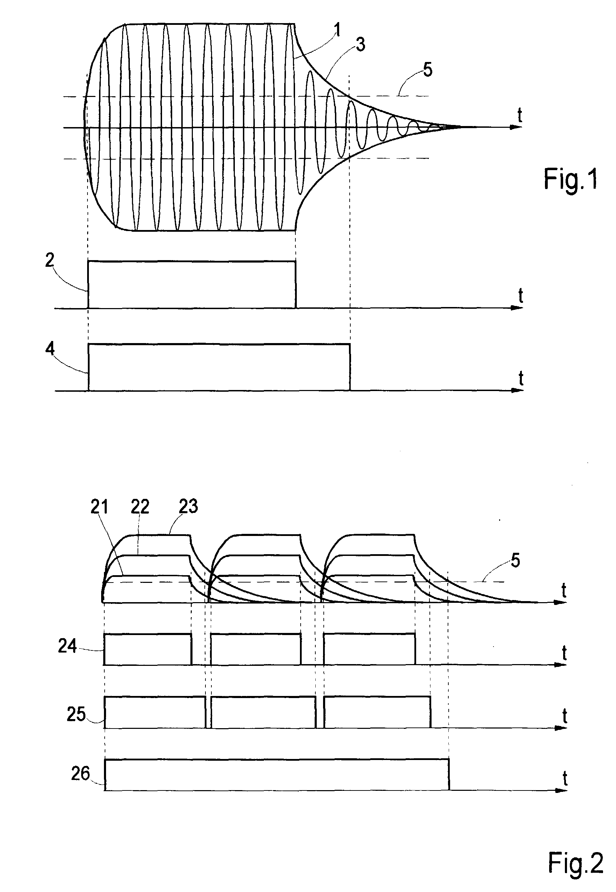

Fig. 1 zeigt einen Signalimpuls 1, der von einer Sendeeinrichtung nach Modulation eines Trägers mit einem Rechteckimpuls 2 ausgesendet wurde. Nach Empfang des Signalimpulses 1 in einem Empfänger wird dessen Hüllkurve 3 gebildet. Zur Erzeugung eines Rechteckimpulses 4 wird die Hüllkurve 3 über eine Komparatorschwelle 5 geführt.

In Fig. 2 sind Hüllkurven 21, 22, 23 von Signalen unterschiedlicher Pegel dargestellt. Durch Demodulierung über eine feststehende Komparatorschwelle 5 werden aus den Hüllkurven 21, 22, 23 Rechtecksignale 24, 25, 26 generiert. Je höher der Signalpegel ist, desto dichter rücken die Rechteckimpulse der demodulierten Signale 24, 25, 26 zusammen, bis sie im Falle des höchsten Signalpegels von 23 gar nicht mehr unterschieden werden.

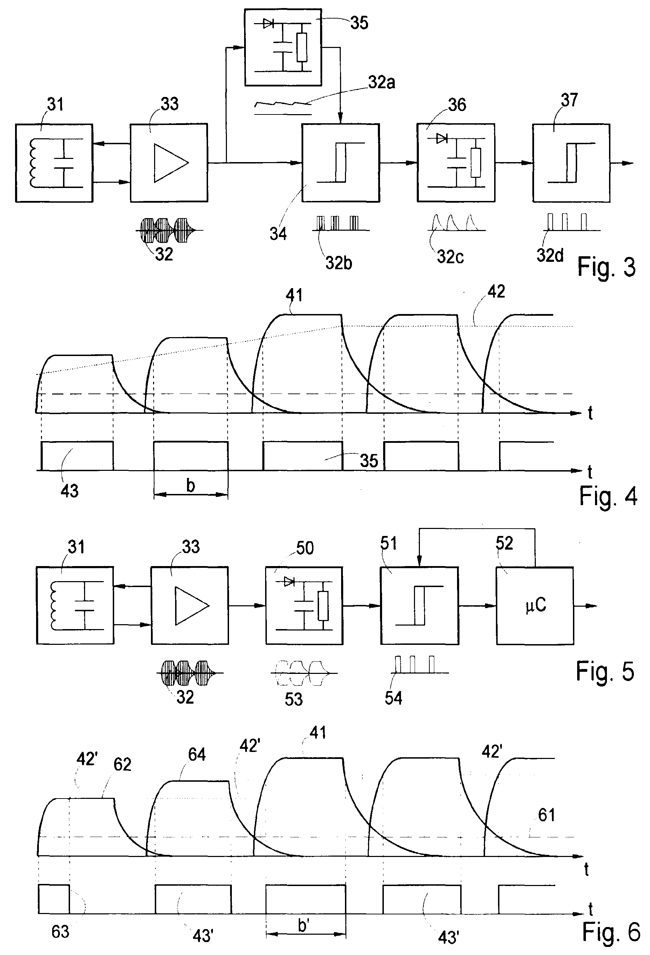

Bei dem in Fig. 3 dargestellten Blockschaltbild wird ein von einer Sendeeinrichtung 31 empfangenes Signal 32 in einem Verstärker 33 verstärkt und einem ersten Komparator 34 mit einstellbarer Schwelle sowie einem Spitzenwertgleichrichter 35 zugeführt. Der Gleichrichter 34 erzeugt eine Spitzenwertkurve 32a des Signals 32, welche zur Nachführung der Komparatorschwelle dem ersten Komparator 34 zugeführt wird. Der Komparator 34 erzeugt ein Rechtecksignal 32b hoher Frequenz, welches über einen Hüllkurvengenerator 36 in einen Hüllkurvenverlauf 32c und schließlich über einen weiteren, mit einer festen Schwelle arbeitenden Komparator 37 in ein Rechtecksignal 32d umgesetzt wird. Das Rechtecksignal 32d kann von einem Mikro-Controller weiterverarbeitet werden.

Fig. 4 zeigt ein Signal 41, welches über eine kontinuierlich nachgeführte Komparatorschwelle 42 in ein Rechtecksignal 43 umgesetzt wird. Die Komparatorschwelle 42 wird derart nachgeführt, daß die Breite b der resultierenden Rechteckimpulse 43 etwa konstant bleibt.

Auch zur stufenweisen Regelung der Komparatorschwelle kann, wie in Fig. 5 gezeigt, ein Mikro-Controller 52 verwendet werden. Über einen Hüllkurvendemodulator 50 wird ein empfangenes Signal 32 in ein Hüllkurvensignal 53 umgesetzt. Das Hüllkurvensignal 53 wird mit einem Komparator 51 in ein Rechtecksignal 54 gewandelt. Die Komparatorschwelle wird von dem nachgeordneten Mikro-Controller 52 entsprechend Fig. 6 geregelt.

In Fig. 6 erfolgt die Nachführung der Komparatorschwelle 42' stufenweise zwischen den einzelnen Impulsen des Signals 41. Zu Beginn einer Datenübertragung wird die Komparatorschwelle von einem untersten Wert 61 rampenartig erhöht und der erste empfangene Signalimpuls 62 über die derartig ansteigende Komparatorschwelle demoduliert und in einen ersten Rechteckimpuls 63 umgesetzt. Mit der Breite dieses Rechteckimpulses 63 wird ein Anfangswert der Komparatorschwelle 42' bestimmt und die Komparatorschwelle vor Auftreten des nächsten Signalimpulses 64 auf diesen Wert gesetzt.

Aus der Breite b' des jeweils erzeugten Rechteckimpulses 43' wird der neu zu setzende Wert der Komparatorschwelle 42' derart bestimmt, daß die Impulsbreite des Rechtecksignals 43' etwa konstant bleibt. Vor jedem neuen Impuls des Signals 41 wird die Komparatorschwelle 42' auf diesen neuen Wert gesetzt.

## Patentansprüche

1. Verfahren zur drahtlosen elektromagnetischen Übertragung von Daten als binäre Signale, welche als amplitudenmoduliertes Signal von einer Sendeeinrichtung ausgesendet, von einer Empfangseinrichtung empfangen und über eine einstellbare Komparatorschwelle in ein Rechtecksignal umgesetzt werden, dadurch gekennzeichnet, daß die Impulsbreite (b, b') des demodulierten Signals (43, 43') durch Nachführen der Komparatorschwelle (42, 42') auf einem wenigstens abschnittsweise bestimmten Sollwert gehalten wird.

2. Verfahren nach Anspruch 1, dadurch gekennzeichnet, daß der Sollwert der Impulsbreite (b, b') des demodulierten Signals (43, 43') wenigstens abschnittsweise konstant vorgegeben ist.

3. Verfahren nach einem der vorhergehenden Ansprüche, dadurch gekennzeichnet, daß die Impulsbreite des demodulierten Signals auf den Sollwert geregelt wird mit der Komparatorschwelle als Stellgröße.

4. Verfahren nach einem der vorhergehenden Ansprüche, dadurch gekennzeichnet, daß das Signal (32) einem Spitzenwertgleichrichter (35) zugeführt wird und daß die Komparatorschwelle anteilig dem Spitzenwert (32a) nachgeführt wird.

5. Verfahren nach einem der vorhergehenden Ansprüche, dadurch gekennzeichnet, daß zur Demodulation die Hüllkurve (32c) des Signals gebildet wird.

6. Verfahren nach Anspruch 3, dadurch gekennzeichnet, daß die Schwingungen des Signals, welche die Komparatorschwelle überschreiten, gezählt werden und somit ein Maß für die Impulsbreite abgeleitet wird.

7. Verfahren nach Anspruch 3, dadurch gekennzeichnet, daß die Impulsbreite (b, b') des demodulierten Signals (43, 43') bestimmt und mit dem Sollwert verglichen wird und daß in Abhängigkeit von dem Ergebnis des Vergleichs die Komparatorschwelle (42, 42') nachgeführt wird.

8. Verfahren nach einem der vorhergehenden Ansprüche, dadurch gekennzeichnet, daß die Komparatorschwelle (42) kontinuierlich nachgeführt wird.

9. Verfahren nach Anspruch 7, dadurch gekennzeichnet, daß zu Beginn einer Übertragung ein erster empfangener Impuls (52) des Signals (41) über eine von einem vorgegebenen untersten Wert (51) stetig ansteigende Komparatorschwelle (42') geführt wird und daß die Breite des daraus resultierenden Impulses (53) bestimmt und daraus ein Wert für die Komparatorschwelle (42') ermittelt wird, der beim nächsten empfangenen Impuls (54) angewendet wird.

10. Verfahren nach Anspruch 7 oder 9, dadurch gekennzeichnet, daß vor jedem voraussichtlich zu empfangenden neuen Impuls des zu empfangenden Signals (41) die Komparatorschwelle (42') auf einen neuen Wert gesetzt wird, der anhand der Impulsbreite (b') des vorherigen Impulses ermittelt wird, und daß der nächste empfangene Impuls des Signals (41) zur Demodulation und Bestimmung der nächsten Impulsbreite über die neu gesetzte Komparatorschwelle (42') geführt wird.

11. Verfahren nach einem der vorhergehenden Ansprüche, dadurch gekennzeichnet, daß das empfangene Signal (32) parallel einem ersten Komparator (34) und einer Vorrichtung (35) zur Nachführung der Komparatorschwelle zugeführt wird und daß das Ausgangssignal (32b) des ersten Komparators (34) über ein Hüllkurvenfilter (36) und einen zweiten Komparator (37) mit fester Schwelle geführt und in das Rechtecksignal (32d) gewandelt wird.
